(19) **Europäisches Patentamt / European Patent Office / Office européen des brevets**

(11) **EP 1 483 763 B1**

(12) **FASCICULE DE BREVET EUROPEEN**

(45) Date de publication et mention
de la délivrance du brevet:
**07.11.2007 Bulletin 2007/45**

(51) Int Cl.:
*G11C 14/00* (2006.01)  *H03K 3/356* (2006.01)
*G11C 5/00* (2006.01)

(21) Numéro de dépôt: **03739529.0**

(22) Date de dépôt: **11.02.2003**

(86) Numéro de dépôt international:
**PCT/FR2003/000448**

(87) Numéro de publication internationale:
**WO 2003/069628 (21.08.2003 Gazette 2003/34)**

(54) **EXTRACTION D UN CODE BINAIRE A PARTIR DE PARAMETRES PHYSIQUE   S D UN CIRCUIT INTEGRE**

EXTRAKTION EINES BINÄRCODES AUS DEN PHYSISCHEN PARAMETERN EINER INTEGRIERTEN SCHALTUNG

EXTRACTION OF A BINARY CODE FROM THE PHYSICAL PARAMETERS OF AN INTEGRATED CIRCUIT

(84) Etats contractants désignés:
**DE FR GB IT**

(30) Priorité: **11.02.2002  FR 0201638**
**29.10.2002  FR 0213556**

(43) Date de publication de la demande:
**08.12.2004  Bulletin 2004/50**

(73) Titulaire: **STMicroelectronics S.A.**
**92120 Montrouge (FR)**

(72) Inventeurs:
• **BARDOUILLET, Michel**
**F-13790 Rousset (FR)**
• **RIZZO, Pierre**
**F-13100 Aix en Provence (FR)**
• **MALHERBE, Alexandre**
**F-13530 Trets (FR)**
• **WUIDART, Luc**
**F-83910 Pourrières (FR)**

(74) Mandataire: **de Beaumont, Michel**
**Cabinet Michel de Beaumont**
**1, rue Champollion**
**38000 Grenoble (FR)**

(56) Documents cités:
**EP-A- 0 511 560**  **EP-A- 0 863 546**
**WO-A-03/069626**  **US-A- 5 708 291**

• **PATENT ABSTRACTS OF JAPAN vol. 014, no. 200 (E-0920), 24 avril 1990 (1990-04-24) & JP 02 042760 A (NIPPON DENSO CO LTD;OTHERS: 01), 13 février 1990 (1990-02-13)**

**Description**

La présente invention concerne le stockage, dans un circuit intégré, d'un code binaire immuable. L'invention concerne plus particulièrement l'extraction, d'un circuit intégré, d'un code binaire issu de paramètres liés à la fabrication de ce circuit. De tels paramètres liés à la fabrication sont généralement appelés des paramètres physiques et sont alors issus d'un réseau de paramètres physiques (PPN). On utilise un code binaire ainsi "enfoui" dans un circuit intégré, par exemple, pour éviter son stockage permanent sous forme de mot numérique dans un registre ou analogue et pour empêcher une détection de ce code. Dans une application à l'identification d'un élément ou ensemble électronique à partir de paramètres liés à la fabrication d'un circuit d'identification contenu dans une puce de circuit intégré, cette identification est couramment désignée par l'expression anglo-saxonne "integrated circuit fingerprint".

La présente invention concerne plus particulièrement l'extraction d'un code binaire stocké sous la forme de chemins électriques au moins partiellement résistifs et interprété par des bascules ou équivalent. Des exemples de circuits de stockage de tels codes binaires, et d'identification d'une puce de circuit intégré par de tels codes, sont décrits dans les demandes de brevet français numéros 2 823 340 (B4998) et 2 823 341 (B4969) de la demanderesse.

Le principe utilisé par ces circuits est de faire circuler un même front électrique déclencheur d'une lecture dans des chemins électriques différents arrivant sur différentes bascules. Selon que le retard d'un chemin donné est inférieur ou supérieur à un retard de référence ou retard moyen synchronisant la lecture des bascules, l'état de sortie de la bascule correspondante est 0 ou 1. Les sorties des différentes bascules fournissent alors le code binaire stocké sous forme de chemins électriques. Ces chemins électriques peuvent être rendus différents simplement par la longueur des pistes les constituant, mais il est préférable qu'ils contiennent un élément résistif (en pratique associé à un élément capacitif constitué des grilles de transistors MOS constitutifs des bascules) pour constituer une cellule RC.

Un atout considérable d'un tel stockage d'un code binaire est qu'il est stocké, non pas directement sous forme numérique, mais en quelque sorte sous une forme analogique, ce qui rend plus difficile son piratage.

Dans les circuits susmentionnés, pour répondre à l'objectif de rendre invisible le code stocké par les chemins électriques, on doit veiller à ce que ces chemins ne soient pas trop différents (en termes de longueur) par rapport au chemin électrique apportant le retard de référence. Dans le cas contraire, on risque de permettre une détection optique selon que le chemin est manifestement plus long ou plus court que le chemin de référence.

Par ailleurs, dans certains cas et de façon parfaitement aléatoire et imprévisible, un chemin électrique d'une des bascules peut, associé à la propagation du front dans cette bascule, présenter exactement le même retard que le chemin moyen. On risque alors, pour cette bascule, d'avoir un état de sortie non reproductible d'une extraction à une autre du code binaire.

Ces deux imperfections des circuits de stockage susmentionnés sont liées à l'utilisation d'un retard moyen pour synchroniser la lecture des bascules.

Une autre technique d'extraction d'un code binaire consiste à détecter une différence de résistance entre deux branches d'une cellule. Cette différence est lue par une mesure de tension ou de courant. Là encore, dans le cas où les deux résistances de la cellule seraient identiques, on obtient un état non reproductible d'une extraction à une autre du code binaire.

Un problème qui se pose quel que soit le mode de lecture (temps, courant, tension) est lié au risque théorique d'avoir deux résistances rigoureusement identiques.

Un autre problème est de rendre invisible (notamment optiquement) les différences entre des résistances fournissant des bits de valeurs différentes.

La demande de brevet européen N°0 863 546 décrit un pseudo-fusible comportant entre deux contacts une région de silicium revêtue d'une région de siliciure comprenant une portion de section réduite revêtue d'une couche de diélectrique.

La demande de brevet européen N°0 511 560 décrit un élément de stockage programmable incluant un circuit anti-fusible programmable ayant plusieurs résistances et un circuit de commutation.

L'invention vise à améliorer l'extraction d'un code binaire enfoui dans un circuit intégré.

L'invention vise également à proposer un circuit de stockage d'un code binaire issu de paramètres physiques d'un circuit intégré qui pallie les imperfections des circuits susmentionnés.

Dans une mesure de temps de propagation, l'invention vise plus particulièrement à éviter le recours à un chemin électrique commun, de référence ou moyen, pour comparer les chemins électriques associés aux différentes bascules.

L'invention vise également à rendre indétectables les retards apportés par les différents chemins électriques d'un tel circuit à bascule, ou les différences entre les résistances d'une cellule de mesure en tension ou courant.

L'invention vise également à proposer une solution qui soit compatible avec la technologie couramment utilisée pour la réaliréalisation de transistors MOS et qui, en particulier, n'engendre pas d'étape supplémentaire de fabrication.

Pour atteindre ces objets et d'autres, la présente invention prévoit une cellule intégrée selon la revendication 1.

Selon un mode de réalisation de la présente invention, ladite modification de valeur consiste à diminuer, de façon irréversible et stable dans la plage de courants de fonctionnement en lecture de la cellule, la valeur d'une desdites résistances.

Selon un mode de réalisation de la présente invention, les résistances sont en silicium polycristallin et sont dimensionnées pour avoir des valeurs nominales identiques.

Selon un mode de réalisation de la présente invention, ladite diminution de valeur est provoquée en imposant temporairement, dans la résistance correspondante, la circulation d'un courant qui soit supérieur au courant pour lequel la valeur de cette résistance est maximum.

Selon un mode de réalisation de la présente invention, la cellule est appliquée à l'extraction d'une valeur binaire à partir d'une propagation d'un front d'un signal de déclenchement dans deux chemins électriques, et comporte, entre deux bornes d'application d'une tension, deux branches parallèles comprenant chacune, en série :

une desdites résistances de différenciation des chemins électriques ;
un transistor de lecture, le point milieu entre la résistance et le transistor de lecture de chaque branche définissant une borne de sortie de la cellule, et la grille du transistor de lecture de chaque branche étant reliée à la borne de sortie de l'autre branche ; et
un transistor de sélection.

Selon un mode de réalisation de la présente invention, chaque branche comporte en outre un transistor de stabilisation reliant sa borne de sortie à ladite borne d'application de tension opposée à celle à laquelle est connectée la résistance de la branche concernée.

Selon un mode de réalisation de la présente invention, les transistors de stabilisation servent à provoquer ladite diminution de la valeur d'une des résistances.

Selon un mode de réalisation de la présente invention, ladite tension est choisie entre une tension relativement faible de lecture et une tension relativement élevée de stabilisation de l'état initial de la cellule.

Selon un mode de réalisation de la présente invention, la cellule comporte :

deux branches parallèles comprenant chacune une desdites résistances connectée entre une première borne d'alimentation et une borne de lecture différentielle de l'état de la cellule ; et
au moins un interrupteur de programmation reliant une desdites bornes de lecture à une deuxième borne (M) d'application de la tension d'alimentation.

Selon un mode de réalisation de la présente invention, chaque branche comporte un interrupteur de programmation.

Selon un mode de réalisation de la présente invention, une des bornes d'alimentation est reliée, par l'intermédiaire d'un sélecteur, à au moins deux tensions d'alimentation parmi lesquelles une tension d'alimentation de fonctionnement en lecture relativement faible et une tension d'alimentation de stabilisation relativement élevée.

Selon un mode de réalisation de la présente invention, au moins un transistor de sélection est associé en série avec chaque dite résistance entre ladite première borne d'alimentation et ladite borne de lecture correspondante.

Selon un mode de réalisation de la présente invention, chaque dite résistance est connectée à la deuxième borne d'alimentation par un interrupteur de verrouillage dont la borne de commande est reliée à la résistance de l'autre branche.

Selon un mode de réalisation de la présente invention, la cellule comporte un amplificateur différentiel de lecture de l'état de la cellule.

Selon un mode de réalisation de la présente invention, chaque branche comporte, de part et d'autre de sa résistance, respectivement un transistor à canal N et un transistor à canal P, dont les grilles sont connectées ensemble à une borne de la résistance de l'autre branche.

L'invention prévoit également un procédé de programmation d'une cellule mémoire consistant, pour rendre irréversible le signe de la différence entre les deux résistances, à imposer temporairement, dans l'une des résistances, la circulation d'un courant de stabilisation supérieur à un courant pour lequel la valeur de la résistance de la branche concernée présente un maximum.

Selon un mode de mise en oeuvre de la présente invention, le procédé comprend les étapes suivantes :

augmenter pas à pas le courant dans la résistance sélectionnée ; et
mesurer, après chaque application d'un courant supérieur, la valeur de cette résistance dans son environnement fonctionnel de lecture.

Selon un mode de mise en oeuvre de la présente invention, une table prédéterminée de correspondance entre le courant de stabilisation et la résistance finale souhaitée est utilisée pour appliquer, à la résistance de programmation sélectionnée, le courant de programmation adapté.

Selon un mode de mise en oeuvre de la présente invention, le procédé comprend les étapes suivantes :

provoquer une lecture d'un état initial de la cellule ; et
soumettre temporairement, celle des résistances qui est associée à la branche fournissant un état haut en sortie, à un courant de contrainte supérieur à un courant pour lequel la valeur de la résistance présente un maximum.

Selon un mode de mise en oeuvre de la présente invention, le courant de contrainte est choisi dans une table prédéterminée de correspondance entre le courant de contrainte et la résistance finale souhaitée.

L'invention prévoit également un circuit de stockage et d'extraction d'un code binaire sur n bits dans une puce de circuit intégré comportant :

n cellules ; et
une unité centrale de commande.

Selon un mode de réalisation de la présente invention, les n bits contenus dans les cellules sont extraits en parallèle.

L'invention prévoit également un circuit d'identification d'une puce de circuit intégré.

Ces objets, caractéristiques et avantages, ainsi que d'autres de la présente invention seront exposés en détail dans la description suivante de modes de mise en oeuvre et de réalisation particuliers faite à titre non limitatif en relation avec les figures jointes parmi lesquelles :

la figure 1 représente un premier mode de réalisation d'une cellule intégrée de stockage d'un bit sous forme de chemin électrique selon un mode de réalisation de la présente invention ;
la figure 2 représente, par une vue partielle en perspective très schématique, un mode de réalisation d'une résistance en silicium polycristallin constitutive d'un chemin électrique selon la présente invention ;
la figure 3 illustre, par un réseau de courbes, la stabilisation de la valeur d'un chemin électrique selon un mode de mise en oeuvre de la présente invention ;
la figure 4 représente, sous forme de blocs, un mode de réalisation d'un circuit de stockage et d'extraction d'un code binaire selon un mode de réalisation de l'invention.
la figure 5 représente le schéma électrique d'une colonne de cellules de stockage selon un autre mode de réalisation de l'invention ;
la figure 6 représente le schéma électrique d'un mode de réalisation de l'amplificateur de lecture différentiel de la figure 5 ;
la figure 7 représente le schéma électrique d'un autre mode de réalisation du circuit de lecture différentiel de la figure 5 ;
la figure 8 représente le schéma électrique d'une cellule de stockage selon un autre mode de réalisation de l'invention ;
la figure 9 représente un exemple de réalisation d'un amplificateur avec trigger de Schmitt utilisé dans le mode de réalisation de la figure 8 ; et
la figure 10 représente le schéma électrique d'une cellule de stockage selon un autre mode de réalisation de la présente invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les différents circuits de lecture et d'exploitation des mots binaires stockés dans un circuit selon l'invention n'ont pas été détaillés. L'invention peut être mise en oeuvre quelle que soit l'exploitation faite du code binaire fonction des paramètres physiques du circuit intégré. De plus, la réalisation pratique d'une résistance en silicium polycristallin par dépôt et gravure n'a pas été détaillée, l'invention pouvant être mise en oeuvre sur une résistance formée de façon classique.

Une caractéristique de l'invention est de détecter une différence initiale (native) entre des résistances passives conditionnant un état binaire à extraire, et de confirmer ou stabiliser (rendre invariable) le signe de cette différence quel qu'il soit.

Dans un mode de réalisation appliqué à une mesure temporelle, une caractéristique de la présente invention est de prévoir, au sein même de chaque élément de lecture ou d'extraction de type bistable ou bascule fournissant un bit d'un code binaire enfoui, un chemin électrique de référence à comparer avec un chemin électrique représentatif du bit enfoui. Plus précisément, l'invention prévoit, pour chaque bit d'un code binaire mémorisé sous la forme de chemins électrique ayant des constantes de temps différentes, une structure différentielle d'extraction du bit correspondant.

Dans un autre mode de réalisation appliqué à une mesure différentielle de tension ou de courant, une caractéristique de la présente invention est de provoquer une lecture de la différence entre les résistances par une conversion résistance-tension à courant constant ou résistance-courant à tension constante. Cette lecture, appliquée à l'état initial (natif ou issu de fabrication) sert à détecter le signe de la différence entre les résistances qui est ensuite confirmé ou stabilisé comme on le verra par la suite.

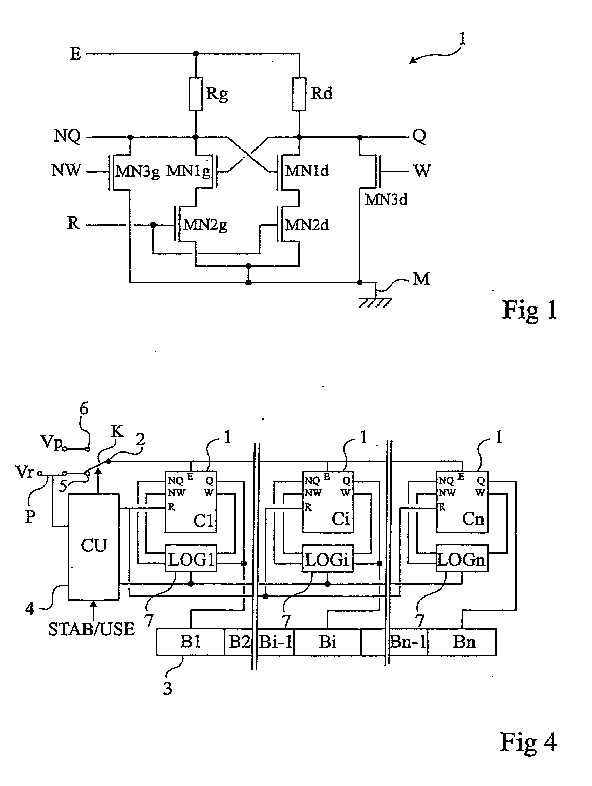

La figure 1 représente le schéma électrique d'une cellule 1 d'extraction d'un bit stocké sous la forme d'un chemin électrique selon un mode de réalisation de la présente invention.

La cellule 1 comprend deux branches parallèles de constitution identique entre deux bornes E et M d'application d'une tension, la borne M représentant la masse. Cette tension qui alimente la cellule est, comme on le verra par la suite, différente selon que l'on effectue une extraction ou lecture du bit, ou une étape caractéristique de stabilisation ou de confirmation de ce bit.

Une première branche, dite droite dans l'orientation de la figure, comporte en série, une résistance Rd, un premier transistor MOS de lecture MN1d, et un deuxième transistor MOS de sélection MN2d. L'interconnexion entre la résistance Rd et le transistor MN1d (donc le drain de ce transistor) constitue une première borne Q de sortie dite arbitrairement directe (non inversée). Une deuxième branche, dite gauche dans l'orientation de la figure, comporte en série, une résistance Rg, un premier transistor MOS de lecture MN1g, et un deuxième transistor MOS de sélection MN2g. L'interconnexion entre la résistance Rg et le transistor MN1g (donc le drain de ce transistor) constitue une deuxième borne NQ de sortie inverse par rapport à la borne Q. La grille du transistor MN1g est reliée à la borne Q tandis que la grille du transistor MN1d est reliée à la borne NQ pour obtenir l'effet bistable recherché. Les grilles des transistors MN2g et MN2d sont reliées ensemble à une borne R destinée à recevoir un signal de sélection en lecture de la cellule 1. Dans l'exemple représenté, tous les transistors sont à canal N.

Selon l'invention, les résistances Rg et Rd sont, en fabrication, dimensionnées de façon identique pour avoir la même valeur. Ces résistances font partie des chemins électriques associés à la cellule 1. Elles définissent, chacune avec la grille du transistor de la branche opposée avec laquelle elles sont respectivement reliées, une cellule RC. Ces cellules RC conditionnent les constantes de temps des chemins électriques reliant la borne E aux bornes Q et NQ, respectivement.

Le fonctionnement d'une cellule selon l'invention telle que décrite ci-dessus est, en lecture, le suivant. La borne d'entrée R reçoit un signal de configuration en lecture ou d'extraction (état haut), rendant conducteur les deux transistors MN2g et MN2d.

Par la suite, on applique un front (positif avec les polarités de ce mode de réalisation) sur l'entrée E de la cellule décrite ci-dessus. L'apparition de ce front sur les bornes Q et NQ devrait être simultanée si les composants étaient tous rigoureusement identiques. En pratique, ce n'est pas le cas, ne serait-ce qu'en raison des dispersions technologiques et de procédé de fabrication. Il en découle qu'une des bornes Q et NQ voit son potentiel croître plus vite que l'autre. Ce déséquilibre provoque la conduction d'un des transistors MN1g et MN1d. En raison du croisement des grilles de ces transistors, celui qui conduit le premier est celui dont la grille participe au chemin électrique de constante de temps la plus faible, donc celui dont le potentiel de drain croît moins vite que l'autre. Une fois conducteur, ce transistor MN1 force son drain (donc la borne de sortie Q ou NQ correspondante) à la masse, ce qui confirme le blocage du transistor MN1 de l'autre branche, donc l'état haut sur la borne de sortie correspondante.

En supposant que la constante de temps ne diffère qu'en raison d'une différence entre les résistances (ou que les autres dispersions sont négligeables par rapport à l'écart de valeur entre les résistances), la résistance de valeur la plus faible engendre une constante de temps plus faible.

La durée du signal d'extraction appliqué sur l'entrée E n'a pas d'importance. Il s'agit d'un signal "numérique" à deux états, l'extraction ou lecture étant provoquée, dans cet exemple, par le front montant. Par la suite, la disparition de l'état haut supprime l'alimentation de la cellule, donc le bit stocké.

Pour préserver le caractère indécelable du code et le rendre dépendant des dispersions technologiques et de procédés de fabrication, il est important que les résistances Rg et Rd soient prévues identiques et que seule leur dispersion (par essence, non observable) conditionne, en sortie de fabrication, le bit extrait de la cellule. Même si les résistances Rg et Rd sont rigoureusement identiques, la constitution de la cellule 1 fait qu'elle ne peut pas présenter un état indéterminé. Elle prendra forcément un état, par exemple, selon d'autres dispersions (entre les transistors, entre les chemins amenant le front depuis la borne E, etc.).

On voit déjà apparaître un avantage de l'invention selon ce mode de réalisation qui est que, pour lire le contenu d'une cellule, aucune comparaison par rapport à un élément externe à la cellule n'est nécessaire.

Pour garantir une reproductibilité de l'état (bit) de la cellule à chaque lecture, on prévoit, selon une autre caractéristique de l'invention, de stabiliser ce contenu lors d'une première lecture. En d'autres termes, lors d'une phase de mise en route, de première utilisation, de configuration ou analogue, on effectue une première lecture du bit issu des paramètres physiques, puis on déclenche une étape de stabilisation de la cellule.

Par stabilisation, on entend au sens de l'invention, une confirmation durable de la valeur native (issue de fabrication) de la cellule.

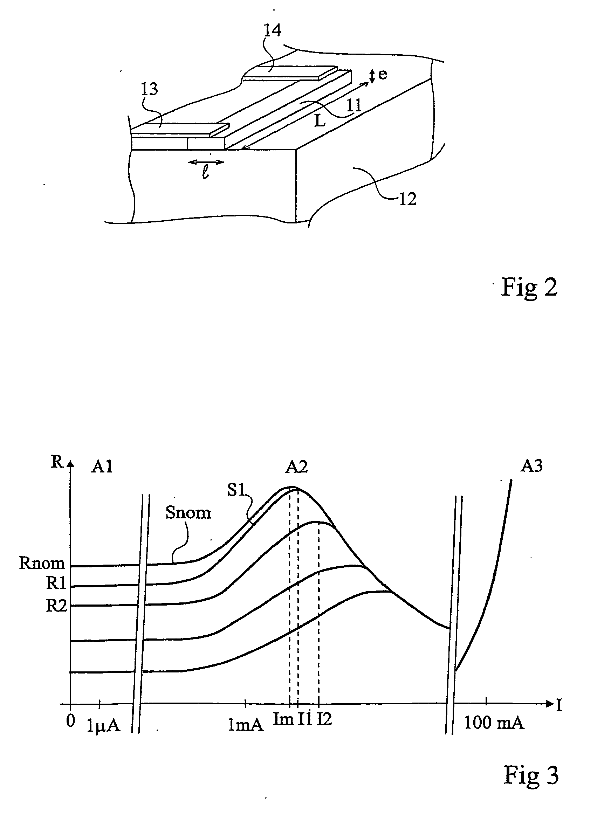

Pour ce faire, les résistances Rg et Rd sont, selon une caractéristique de l'invention, des résistances en silicium polycristallin dont les valeurs respectives peuvent faire l'objet d'une diminution irréversible, comme cela sera exposé par la suite en relation avec les figures 2 et 3. Pour l'instant, on se contente de noter que si la résistance Rg ou Rd est soumise à un courant, dit de stabilisation ou confirmation, supérieur au courant pour lequel sa valeur est maximale, on assiste à une diminution irréversible de la valeur de sa résistance lorsque l'on revient à des courants situés dans la plage nominale de fonctionnement. La plage nominale des courants de fonctionnement d'une résistance en silicium polycristallin utilisée selon l'invention est inférieure à la centaine de microampères et, le plus souvent, inférieure à la dizaine de microampères. L'amplitude des courants de stabilisation est de l'ordre de quelques milliampères.

Selon l'invention, l'étape de stabilisation consiste à soumettre à un courant élevé par rapport à la plage de courants de fonctionnement, la résistance de la branche qui a, lors d'une première lecture, présenté un état haut (indiquant donc, en principe une résistance de valeur moindre). Cela confirme alors l'état de la cellule en diminuant de façon notable la valeur de cette résistance. Bien sûr, le courant de stabilisation ne doit pas être appliqué à l'autre résistance, faute de quoi, elle subirait une diminution de valeur identique, ce qui annulerait l'effet de confirmation escompté.

Pour imposer, dans l'une des résistances Rg et Rd, un courant de stabilisation, supérieur aux courants de fonctionnement de cette résistance, la borne E sert, en phase de stabilisation, d'application d'un potentiel continu d'alimentation Vp (ici positif). Ce potentiel d'alimentation est, selon l'invention, supérieur au potentiel Vr d'utilisation de la cellule en lecture, c'est-à-dire au potentiel haut du front appliqué sur la borne E. De plus, on prévoit deux transistors MOS MN3d et MN3g (dans cet exemple à canal N) respectivement associés à chacune des branches en reliant la borne Q, respectivement NQ à la masse. Les grilles respectives des transistors constituent deux bornes W et NW d'entrée de commande en stabilisation de la cellule. Un seul des transistors MN3g et MN3d est destiné à être rendu passant pendant l'étape de stabilisation.

Celui des transistors MN3g et MN3d qui est passant court-circuite les deux autres transistors MN1 et MN2 de la branche concernée, et impose la circulation d'un courant dans la résistance Rg ou Rd de cette branche. Le potentiel Vp de stabilisation est choisi pour que le courant qui circule alors dans la résistance Rg ou Rd soit supérieur au courant pour lequel cette résistance présente une valeur maximale. Cette caractéristique de l'invention ressortira mieux de la description qui sera faite par la suite en relation avec les figures 2 et 3.

Les transistors MN2g et MN2d de la cellule doivent être bloqués dans la phase de stabilisation (entrée R au niveau bas). Ils servent à protéger les transistors de lecture MN1g et MN2g en rendant leurs sources flottantes. En déconnectant les transistors MN1, les transistors MN2 empêchent qu'ils voient à leurs bornes la tension élevée Vp. Par conséquent, les transistors MN1 et MN2 peuvent être dimensionnés en fonction de la tension de lecture Vr. Seuls les transistors MN3g et MN3d ont besoin d'être dimensionnés pour tenir la tension Vp et supporter le courant relativement élevé (par rapport à la plage de fonctionnement en lecture) servant à stabiliser la cellule.

La figure 2 représente un mode de réalisation d'une résistance en silicium polycristallin utilisée pour former les résistances Rd et Rg d'une cellule selon l'invention.

Une telle résistance (désignée par 11 en figure 2) est constituée d'une piste (dite aussi barreau) en silicium polycristallin obtenue par gravure d'une couche déposée sur un substrat 12 isolant. Le substrat 12 est indifféremment directement constitué du substrat du circuit intégré ou est constitué d'une couche isolante formant un substrat isolant ou équivalent pour la résistance 11. La résistance 11 est connectée, par ses deux extrémités, à des pistes conductrices (par exemple, métalliques) 13 et 14 destinées à raccorder le barreau résistif aux autres éléments du circuit intégré. La représentation schématique de la figure 2 ne fait pas référence aux différentes couches isolantes et conductrices constituant généralement le circuit intégré. Pour simplifier, on s'est contenté de représenter le barreau résistif 11 posé sur le substrat isolant 12 et en contact, par les extrémités de sa face supérieure, avec les deux pistes métalliques 13 et 14. En pratique, les liaisons de l'élément résistif 11 aux autres composants du circuit intégré sont obtenues par des pistes plus larges en silicium polycristallin partant des extrémités du barreau 11 dans l'alignement de celui-ci. En d'autres termes, l'élément résistif 11 est généralement formé en rendant un tronçon d'une piste en silicium polycristallin plus étroit que le reste de la piste.

La résistance R de l'élément 11 est donnée par la formule suivante :

$$R = \rho(L/s),$$

où $\rho$ désigne la résistivité du matériau (silicium polycristallin le cas échéant dopé) constituant la piste dans laquelle est gravé l'élément 11, où L désigne la longueur de l'élément 11, et où s désigne sa section, c'est-à-dire sa largeur l par son épaisseur e. La résistivité $\rho$ de l'élément 11 dépend, entre autres, du dopage éventuel du silicium polycristallin le constituant.

Le plus souvent, lors de la réalisation d'un circuit intégré, on prévoit les résistances en faisant référence à une notion dite de résistance par carreau $R_\square$ (square resistance). Cette résistance par carreau se définit comme étant la résistivité du matériau divisée par l'épaisseur avec laquelle il est déposé. En reprenant la relation ci-dessus donnant la résistance d'un élément 11, la résistance est donc donnée par la relation :

$$R = R_\square * L/l.$$

Le quotient L/l correspond à ce que l'on appelle le nombre de carreaux (square number) constituant l'élément résistif 11. Cela représente, vu de dessus, le nombre de carreaux de dimension donnée fonction de la technologie, mis côte à côte pour former l'élément 11.

La valeur de la résistance en silicium polycristallin est donc définie, à la fabrication, d'après les paramètres ci-dessus, conduisant à des résistivités et résistances dites nominales. Généralement, l'épaisseur e du silicium poly-cristallin est fixée par d'autres paramètres de fabrication du circuit intégré. Par exemple, cette épaisseur est fixée par l'épaisseur souhaitée pour les grilles des transistors MOS du circuit intégré.

Une caractéristique de la présente invention est d'imposer temporairement, dans une résistance en silicium polycristallin (Rg ou Rd) dont on souhaite diminuer irréversiblement la valeur pour stabiliser l'état de la cellule, un courant de programmation ou de contrainte supérieur à un courant pour lequel la résistance passe par une valeur maximale, ce courant étant au-delà de la plage de courants de fonctionnement normal (en lecture) de cette résistance. En d'autres termes, on diminue la résistivité du silicium polycristallin dans la plage de courants de fonctionnement, de façon stable et irréversible, en imposant temporairement dans l'élément résistif correspondant la circulation d'un courant au-delà de la plage de courants de fonctionnement.

Une autre caractéristique de l'invention est que le courant servant à diminuer la valeur de la résistance est, à la différence d'un élément fusible, non destructif pour l'élément en silicium polycristallin.

La figure 3 illustre, par un réseau de courbes donnant la résistance d'un élément en silicium polycristallin du type de celui représenté en figure 2 en fonction du courant le traversant, un mode de mise en oeuvre de la présente invention pour stabiliser une cellule par diminution de la valeur d'une de ses résistances.

On suppose que le silicium polycristallin ayant servi à la fabrication de l'élément résistif 11 (Rg ou Rd) présente une résistivité nominale conférant à l'élément 11, pour les dimensions l, L et e données, une valeur de résistance $R_{nom}$. Cette valeur nominale (d'origine) de la résistance correspond à la valeur prise de façon stable par l'élément résistif 11 dans la plage de courants de fonctionnement du système, c'est-à-dire généralement pour des courants inférieurs à 100 µA.

Selon l'invention, pour diminuer la valeur de la résistance et passer de façon irréversible et stable, par exemple, à une valeur R1 inférieure à $R_{nom}$, on applique aux bornes de l'élément résistif 11 un courant (par exemple I1), dit de contrainte, supérieur à un courant Im pour lequel la valeur de la résistance R de l'élément 11 est maximale sans toutefois être infinie. Comme l'illustre la figure 3, une fois que ce courant I1 a été appliqué à l'élément résistif 11, on obtient, dans la plage A1 de courants de fonctionnement du circuit intégré, une résistance stable de valeur R1. En fait, l'allure $S_{nom}$ de la résistance en fonction du courant est stable pour des courants relativement faibles (inférieurs à 100 µA). Cette allure se met à croître pour des courants sensiblement supérieurs de l'ordre de quelques milliampères, voire plus (plage A2). C'est dans cette plage de courants que l'allure Snom passe par un maximum pour la valeur Im. La résistance décroît ensuite progressivement. En figure 3, on a illustré une troisième plage A3 de courants correspondant à la plage généralement utilisée pour réaliser des fusibles. Il s'agit de courants de l'ordre du dixième d'ampère où la résistance se met à croître brusquement jusqu'à devenir infinie. Par conséquent, on peut considérer que l'invention utilise la plage intermédiaire A2 de courants entre la plage de fonctionnement A1 et la plage destructrice A3, pour diminuer de façon irréversible la valeur de la résistance ou plus précisément de la résistivité de l'élément en silicium polycristallin.

En effet, une fois passé le maximum de l'allure Snom de la résistivité en fonction du courant, la valeur prise par la résistance dans la plage de courants de fonctionnement se trouve inférieure à la valeur $R_{nom}$. La nouvelle valeur, par exemple R1, dépend de la valeur la plus élevée du courant (ici, I1) qui a été appliqué pendant la phase de diminution irréversible. On notera en effet que la diminution irréversible opérée par l'invention s'effectue dans une phase spécifique de stabilisation, hors du fonctionnement normal en extraction (plage A1) du circuit intégré, c'est-à-dire hors du fonctionnement normal de la résistance.

Théoriquement, une fois que la valeur de la résistance en silicium polycristallin a été abaissée vers une valeur inférieure (par exemple R1 en figure 3), on peut encore procéder à une diminution irréversible de cette valeur. Il suffit pour cela de dépasser le courant maximum I1 de la nouvelle allure S1 de la résistance en fonction du courant. Par exemple, on peut accroître la valeur du courant jusqu'à atteindre une valeur I2. Quand le courant est alors de nouveau diminué, on obtient une valeur R2 pour la résistance dans sa plage de fonctionnement normal. La valeur R2 est inférieure à la valeur R1 et, bien sûr, à la valeur $R_{nom}$. Dans l'application à une cellule différentielle d'extraction d'un bit telle que représentée en figure 1, cela montre le caractère irréversible de la stabilisation apportée. Une deuxième phase de stabilisation ne fait, au plus, qu'accroître la diminution de la valeur de la résistance par rapport à sa valeur nominale, donc ne fait que confirmer encore l'état de la première détection.

On voit que toutes les allures de la résistance en fonction du courant se rejoignent sur la pente de décroissance de la valeur de la résistance, après être passées par le maximum de l'allure. Ainsi, pour un élément résistif donné ($\rho$, L, s), les courants I1, I2, etc. qui doivent être atteints pour passer à une valeur de résistance inférieure, sont indépendants de la valeur de la résistance (Rnom, R1, R2) à partir de laquelle on provoque la diminution.

Ce qui a été exprimé ci-dessus comme valeur de résistance correspond en fait à une diminution de la résistivité du silicium polycristallin constituant l'élément résistif. Les inventeurs considèrent que l'on assiste à une modification stable de la structure cristalline du silicium polycristallin et que l'on assiste, en quelque sorte, à un fluage du matériau, la structure cristalline finale obtenue dépendant du courant maximum atteint. En fait, le courant de contrainte provoque une élévation de température de l'élément en silicium, ce qui entraîne un fluage de celui-ci.

Bien sûr, on veillera à ne pas dépasser la plage de courants de programmation A2 (de l'ordre de quelques milliampères) afin de ne pas risquer de détruire la résistance en silicium polycristallin. Cette précaution ne posera en pratique pas de problème dans la mesure où l'utilisation du silicium polycristallin pour constituer un fusible requiert des courants nettement plus élevés (de l'ordre du dixième d'ampère) qui ne sont pas disponibles une fois le circuit fabriqué.

La réalisation pratique d'une résistance en silicium polycristallin selon l'invention ne diffère pas de la réalisation d'une résistance classique. Partant d'un substrat isolant, on dépose une couche de silicium polycristallin que l'on grave en fonction des dimensions souhaitées pour la résistance. Comme l'épaisseur de silicium polycristallin déposée est généralement fixée par la technologie, les deux dimensions que l'on peut régler sont la largeur et la longueur. Généralement, on redépose un isolant sur le barreau de silicium polycristallin ainsi obtenu. Dans le cas d'une interconnexion en ligne, on aura modifié la largeur 1 par rapport aux pistes d'accès plus larges pour être fortement conductrices. Dans le cas d'un accès aux extrémités du barreau par le dessus comme cela est illustré en figure 2, on réalisera des vias dans l'isolant sur-jacent (non représenté) du barreau de silicium polycristallin pour connecter des pistes métalliques 13 et 14 de contact.

En pratique, pour disposer de la capacité de réglage de résistance la plus importante avec un courant de contrainte minimum, on cherchera à utiliser une épaisseur minimale et une largeur minimale pour les éléments résistifs. Dans ce cas, seule la longueur L conditionne la valeur nominale de la résistance une fois la structure du silicium polycristallin fixée. Le dopage éventuel du silicium polycristallin, quel que soit son type, n'entrave pas la mise en oeuvre de l'invention. La seule différence liée au dopage est la résistivité nominale avant contrainte et les résistivités obtenues pour des courants de contrainte donnés. En d'autres termes, pour un élément de dimensions données, cela conditionne le point de départ de la valeur de la résistance, et par voie de conséquence, les valeurs de résistance obtenues pour des courants de contrainte donnés.

Pour être en mesure d'appliquer les bonnes valeurs, on prédétermine, par exemple par mesures, les différents courants à appliquer pour passer des différentes valeurs de résistance à des valeurs inférieures. Par exemple, on utilise une résistance de test que l'on soumet à une augmentation par pallier du courant, en revenant après chaque augmentation dans la plage des courants de fonctionnement pour mesurer la valeur obtenue de résistance. Les.valeurs mesurées vont suivre la courbe Snom. Par conséquent, on pourra déterminer les courants (I1, I2, figure 3) et les résistances associées (R1, R2). L'écart entre les valeurs de la table ainsi obtenue dépend du pas choisi pour l'augmentation par pallier du courant de contrainte. Cette prédétermination tient compte bien entendu de la nature du silicium polycristallin utilisé ainsi que préférentiellement de la résistance par carreau c'est-à-dire de la résistivité du matériau et de l'épaisseur dans laquelle il est déposé. En effet, comme les allures illustrées par la figure 3 peuvent également être lues comme allure de la résistance par carreau, on est en mesure de transposer les valeurs calculées aux différentes résistances d'un circuit intégré définies par les largeurs et longueurs des tronçons résistifs. On est alors en mesure de prédéterminer la valeur du courant de contrainte à appliquer à l'élément résistif pour diminuer, de façon irréversible et stable, sa valeur. Cette détermination permet de fixer la tension Vp utilisée dans la phase de stabilisation. On notera qu'en raison de l'effet souhaité (diminution notable de la valeur d'une des deux résistances appariées), la précision du courant de contrainte n'est pas critique pourvu d'être supérieur au courant maximum Im de la résistance. De préférence, on prendra en pratique une marge de sécurité confortable pour éviter que des variations de la tension Vp ou autres tolérances du circuit empêchent d'obtenir la diminution de valeur. Par exemple, on paramètrera le circuit en fonction d'un courant de stabilisation donnant une valeur de résistance inférieure à la moitié de la valeur nominale.

Le changement de courbes, c'est-à-dire la diminution de la valeur de résistance en fonctionnement normal est quasi immédiate dès que le courant de contrainte correspondant est appliqué. Par quasi-immédiat, on entend une durée de quelques dizaines voir centaines de microsecondes qui suffisent pour appliquer la contrainte correspondante au barreau de silicium polycristallin et diminuer la valeur de sa résistance. Cette valeur empirique dépend de la taille (physique) du barreau. On pourra choisir une durée de quelques millisecondes par sécurité. De plus, on peut considérer que, une fois la durée minimale atteinte, toute durée supplémentaire d'application du courant de contrainte ne modifie pas, au moins au premier ordre, la résistance atteinte. En outre, même si compte tenu des mesures de prédétermination, on considère ne pas pouvoir négliger l'influence de la durée d'application de la contrainte, le mode préféré de mise en oeuvre (prédéterminer des valeurs de contraintes en durée et en intensité) est parfaitement compatible avec la prise en compte de la durée d'application de la contrainte.

A titre d'exemple particulier de mise en oeuvre, on a réalisé une résistance en silicium polycristallin dopée N+ ayant une section de 0,225 micromètre carré (l = 0,9 $\mu$m, e = 0,25 $\mu$m) et une longueur L de 45 micromètres. Avec le silicium polycristallin utilisé et le dopage correspondant, la résistance nominale était d'environ 6300 Ohms. Cela correspond à une résistance par carreau d'environ 126 Ohms (50 carreaux). En appliquant à cette résistance un courant supérieur à trois milliampères, on a provoqué une diminution de sa valeur, stable pour un fonctionnement sous des courants allant jusqu'à 500 microampères. Avec un courant de 3,1 milliampères, la valeur de la résistance a été abaissée à environ 4500 Ohms. En appliquant à la résistance un courant de 4 milliampères, on a diminué la valeur de la résistance jusqu'environ 3000 Ohms. Les valeurs obtenues de résistances ont été les mêmes pour des durées de contraintes allant de 100 microsecondes à plus de 100 secondes.

Bien entendu, les exemples ci-dessus ainsi que les ordres de grandeurs donnés de courants et de résistances pour les différentes plages concernent les technologies actuelles. Les courants des plages A1, A2 et A3 pourront être différents (inférieurs) pour des technologies plus avancées et peuvent être transposés à des densités de courant. Le principe de l'invention n'en est pas modifié. On a toujours trois plages et on utilise la plage intermédiaire pour forcer la diminution de résistivité.

Un avantage de la présente invention est qu'elle est compatible avec les technologies classiques de réalisation des transistors MOS.

Un autre avantage de l'invention est que la valeur intégrée dans les résistances est insensible aux Ultra Violets.

Un autre avantage de l'invention est que le code stocké dans l'élément de mémorisation n'est pas détectable optiquement à la différence d'une résistance en silicium polycristallin qui serait utilisée comme fusible où la détérioration physique du barreau de silicium rend la programmation visible.

Un autre avantage de l'invention est que la modification irréversible de la valeur de la résistance programmée n'est pas destructrice et ne risque donc pas d'endommager d'autres parties du circuit. Cela permet notamment de prévoir une diminution de la valeur de la résistance après fabrication, et même au cours de sa vie dans son circuit applicatif.

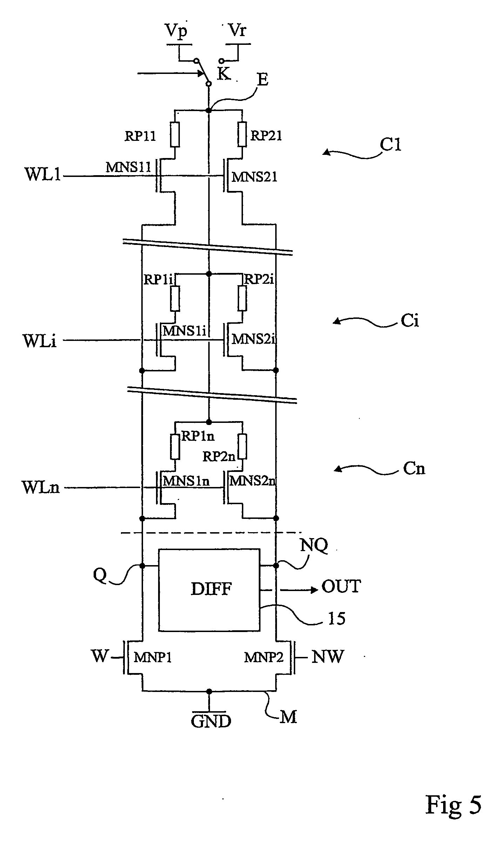

La figure 4 représente le schéma électrique d'un mode de réalisation d'un circuit de stockage intégré associant plusieurs cellules 1 du type de celle représentée en figure 1, pour extraire un mot ou code binaire de plusieurs bits.

Dans cet exemple, le circuit comporte une unique borne 2 d'entrée d'application, selon la phase de fonctionnement, du potentiel Vp ou d'un front de lecture au niveau Vr. Le circuit fournit un code binaire $B_1$, $B_2$, ..., $B_{i-1}$, $B_i$, ..., $B_{n-1}$, $B_n$ sur un nombre n de bits prédéterminé. Chaque bit Bi est fourni par une sortie (par exemple, Q) d'une cellule Ci (i étant compris entre 1 et n). Dans l'exemple de la figure 4, les différentes sorties Q des bascules 1 sont reliées individuellement en entrée d'un registre 3 de mémorisation du code binaire obtenu. Les détails de connexion et de constitution du registre 3 n'ont pas été représentés et ne font pas l'objet de la présente invention. Une fois le code binaire contenu dans ce registre, son exploitation dépend de l'application, et sa mise en oeuvre est à la portée de l'homme du métier.

Le circuit de la figure 4 comporte une unité centrale 4 (CU) commune à toutes les cellules 1. L'unité 4 a notamment pour rôle de placer les cellules dans un fonctionnement de lecture ou de stabilisation. Par exemple, l'unité 4 commande un sélecteur K de connexion de la borne 2 entre une borne 6 d'application de la tension continue Vp et une borne 5 sur laquelle sera appliqué, en lecture, un signal numérique (front d'amplitude Vr) de déclenchement de l'extraction du code. Par exemple, un interrupteur P (par exemple, un transistor MOS) relie la borne 5 à une borne d'application de la tension Vr.

L'unité 4 produit également un signal de commande à destination des bornes R des cellules Ci pour placer celles-ci dans une configuration de lecture ou de stabilisation, ainsi qu'un signal de commande de l'interrupteur P. Dans l'exemple représenté où la lecture s'effectue en parallèle, toutes les bornes R des cellules Ci sont reliées ensemble à la borne correspondante de l'unité 4. En variante, les cellules Ci peuvent être adressées individuellement (par exemple cycliquement) en lecture, pour une extraction en série des différents bits. Il convient alors de veiller à maintenir à l'état haut le signal d'extraction (fermeture de l'interrupteur P) le temps nécessaire à l'extraction de tous les bits.

Pour permettre une stabilisation ou confirmation d'une cellule, il est nécessaire d'en extraire une première fois le contenu et de commander en conséquence la conduction du transistor MN3g ou MN3d. Pour cela chaque cellule Ci est associée à un circuit logique 7 (LOGi) de lecture et d'interprétation pendant la phase de stabilisation.

Chaque circuit 7 comporte deux entrées de détection reliées respectivement aux bornes Q et NQ de la cellule, deux sorties de commande reliées respectivement aux bornes W et NW de commande des transistors MN3d et MN3g de la cellule, et une borne d'entrée de commande destinée à recevoir un signal de commande (d'activation/désactivation) de l'unité 4. Pour simplifier, on nommera les bornes d'entrée-sortie du circuit 7 qui sont reliées à la cellule 1 par les références des bornes de cette cellule. De préférence la stabilisation de toutes les cellules s'effectue en parallèle, c'est pourquoi chacune est associée à son circuit logique 7.

Lorsque le code doit être stabilisé, par exemple, lors d'une première utilisation du circuit, ou lors d'une phase de test après fabrication, un signal de commande STAB/USE que reçoit l'unité 4 déclenche une phase de stabilisation.

L'unité 4 commence par provoquer une extraction de tous les bits. Pour cela, elle place le sélecteur K dans un état où il sélectionne la borne 5, rend passant les transistors MN2 et active les circuits LOGi, puis provoque une commutation vers l'état haut du signal appliqué sur la borne 5. Pour cela, l'unité 4 rend l'interrupteur P passant pour faire apparaître un front positif sur les bornes E des cellules. La durée de fermeture de l'interrupteur P correspond à la durée d'une extraction normale. Dans chaque cellule, on assiste alors à l'apparition d'un état 0 ou 1 sur sa sortie Q. De préférence, toutes les cellules ont des paires de résistances Rg et Rd de mêmes valeurs.

La stabilisation va être décrite en relation avec une cellule, sachant toutefois qu'elle s'effectue de manière similaire pour les autres cellules.

Initialement, les sorties W et NW du circuit LOGi sont au repos (état bas), de sorte que les deux transistors MN3 sont bloqués. Dès que le circuit LOGi détecte un état 1 sur une de ses entrées Q, respectivement NQ, il commute vers l'état haut sa sortie W, respectivement NW, pour rendre conducteur le transistor MN3d, respectivement MN3g, et verrouille cet état conducteur ainsi qu'un état bas sur son autre sortie NW, respectivement W. Ce verrouillage de l'état bas permet de figer la commande par le circuit LOGi alors même que la commutation en fermeture d'un des transistors MN3 inverse l'état des sorties de la cellule. En variante, on peut prévoir d'invalider la détection des états sur les entrées Q et NQ dès qu'un état haut y a été détecté.

Selon un premier mode de réalisation correspondant au mode de réalisation représenté, l'unité 4 déclenche, après une durée prédéterminée choisie pour être supérieure (avec une marge de sécurité) à la durée maximale possible de verrouillage des différents circuits LOGi (qui dépend donc de la constante de temps maximale des différents chemins des cellules en particulier si des cellules différentes ont des valeurs nominales de paires de résistances différentes), l'ouverture des transistors MN2 (état bas sur toutes les entrées R), puis la commutation du sélecteur K vers la borne 6. Il en résulte la circulation d'un courant de stabilisation (de l'ordre de quelques milliampères) dans l'une des résistances de chaque cellule (celle qui correspond à la constante de temps détectée la plus faible. Ce courant dont la valeur est prédéterminée en fonction des caractéristiques nominales des résistances des cellules 1 comme cela a été exposé en relation avec la figure 3 est maintenu, par exemple, pendant une durée de quelques millisecondes. Cela provoque, dans chaque cellule, une diminution irréversible et stable de la valeur de la résistance associée à la constante de temps la plus faible, confirmant ainsi l'état de la cellule.

Puis, l'unité 4 désactive la phase de stabilisation en commutant de nouveau le sélecteur K vers la borne 5 (sans toutefois déclencher une nouvelle extraction par la fermeture de l'interrupteur P) et en désactivant les circuits logiques LOGi. Le cas échéant, l'unité 4 commute également vers un état haut le signal de commande des entrées R. En variante, ce signal est placé à l'état haut, à chaque phase d'extraction, ce qui minimise la consommation en dehors des phases d'extraction.

L'état de chaque cellule est donc désormais stabilisé (confirmé) sans pour autant être détectable. En effet, les résistances Rd et Rg de chaque cellule ont encore les mêmes dimensions.

Selon une variante de réalisation, chaque circuit logique LOGi est associé à un sélecteur entre les niveaux Vp et Vr et comprend une logique de commande en conséquence. Dans ce cas, il n'est pas nécessaire que toutes les cellules passent au niveau Vp en même temps.

En principe, l'étape de stabilisation n'est effectuée qu'une seule fois. Toutefois, il n'est pas gênant qu'elle soit reproduite. Elle ne fera que confirmer le même état.

Un avantage de la présente invention est qu'aucune précaution particulière n'est à prendre pour différencier les chemins électriques stockant le code. Au contraire, les résistances sont fabriquées de façon identique, ce qui accroît encore la dissimulation du code.

Un autre avantage de la présente invention est que le code stocké ainsi ne risque pas d'être détecté, même par une attaque par analyse de la consommation. En effet, la consommation d'une cellule reste inchangée en lecture quelle que soit celle des résistances Rd et Rg qui a vu sa valeur diminuer.

On décrira ci-après d'autres modes de réalisation appliqués à une confirmation de différence de résistances dans une structure différentielle lue par une mesure de courant ou de tension. Ces modes de réalisation reprennent les avantages indiqués en relation avec la description ci-dessus du mode de réalisation temporel, notamment pour ceux qui sont liés à l'utilisation de résistances en silicium polycristallin programmables par diminution irréversibles de leurs valeurs.

La figure 5 représente une colonne de cellules de stockage C1, ... Ci, ... Cn selon un mode de réalisation. Cette figure illustre la possibilité d'association des cellules à résistances de programmation propres à l'invention dans un réseau matriciel. Pour simplifier, la figure 5 ne représente qu'une seule colonne. On notera toutefois que plusieurs colonnes parallèles peuvent être prévues.

Chaque cellule mémoire Ci de la colonne est constituée de deux branches parallèles comprenant chacune, entre une borne E d'application du signal d'activation et une borne respective Q ou NQ de sortie destinée à être lue par un élément de lecture différentiel 15, une résistance programmable RPli, respectivement RP2i, et un interrupteur (ici, un transistor MOS à canal N) MNSli, respectivement MNS2i, de sélection de la cellule de la colonne. Les bornes Q et NQ, correspondant à des bornes d'entrée de l'amplificateur différentiel 15 ou de sortie de l'arrangement de cellules, sont respectivement connectées à la masse GND par l'intermédiaire de transistors de confirmation MNP1 et MNP2 utilisés dans la phase de stabilisation.

Les différentes cellules mémoire Ci sont donc en parallèle entre la borne E et les bornes Q et NQ. Dans l'exemple représenté, la borne E est reliée à des potentiels d'alimentation respectivement de lecture Vr et de stabilisation Vp par l'intermédiaire d'un interrupteur K commandé par un circuit de commande (non représenté) selon la phase de fonctionnement.

Dans l'exemple représenté, les transistors MNP1 et MNP2 reçoivent des signaux respectifs W et NW du circuit de commande. En variante, et comme on le verra par la suite en relation avec certains des modes de réalisation de l'amplificateur différentiel, les signaux W et NW peuvent être un seul et même signal de commande en stabilisation.

Dans le circuit de la figure 5, les transistors de sélection MNS1i et MNS2i de chaque cellule sont commandés ensemble par des signaux respectifs WLi de sélection de lignes de mots. Cette notation de lignes de mots est utilisée en référence aux désignations habituelles des lignes et colonne dans un plan mémoire. En variante, les signaux de sélection de lignes WLi pourront être divisés en deux signaux séparés de sélection d'une branche par rapport à l'autre, notamment si cela est requis pour la stabilisation alors qu'un unique signal de commande est utilisé pour les transistors MNP1 et MNP2 simultanément.

De l'exposé qui précède, on voit bien que chaque cellule comprend, en parallèle entre deux bornes d'application d'une tension d'alimentation, deux branches comprenant chacune une résistance en silicium polycristallin, et au moins un interrupteur de lecture (MUTTS) reliant chaque résistance à une borne de sortie.

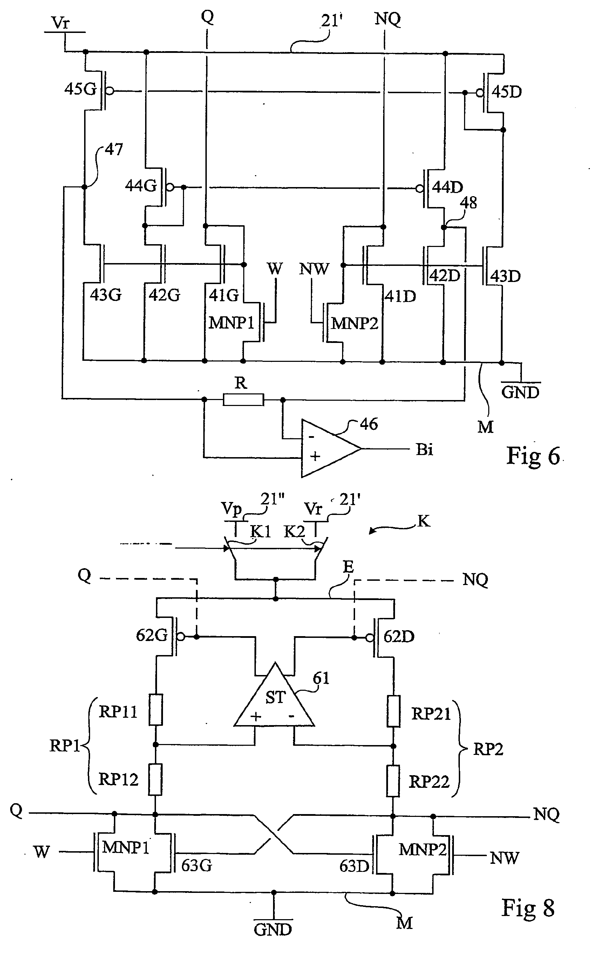

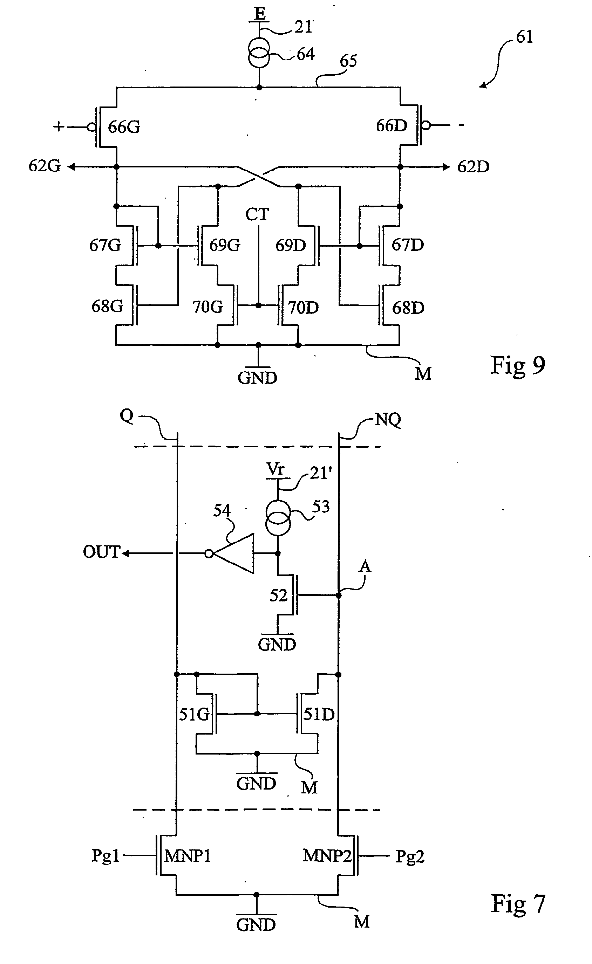

Différents exemples de réalisation d'éléments de lecture différentielle 15 seront décrits ci-après en relation avec les figures 6 et 7. Les transistors de lecture ou sélection y ont été omis en raison de l'unicité de l'élément de lecture pour une colonne entière de cellules telles qu'illustrées par la figure 5.

Les transistors MNP1 et MNP2 ont été représentés pour mieux faire apparaître la liaison avec la figure 5. On notera toutefois que ceux-ci ne font pas à proprement parler partie des éléments de lecture différentielle.

La figure 6 représente un premier exemple d'amplificateur différentiel 15 de lecture détectant une différence de courant entre les deux branches d'une cellule.

Le schéma de la figure 6 est basé sur l'utilisation de deux amplificateurs à transconductance comprenant chacun au moins deux branches parallèles de miroirs de courant. Dans l'exemple représenté, trois branches en parallèles sont prévues pour chacune des branches (Q et NQ) de sortie de la cellule mémoire.

Par exemple, côté borne Q (arbitrairement côté branche gauche dans l'orientation de la figure), chaque branche comprend un transistor 41G, 42G et 43G respectivement (par exemple, des transistors MOS à canal N) montés en miroir de courant. Le transistor 41G relie la borne Q à la masse et est monté en diode, sa grille et son drain étant interconnectés. Le transistor 42G de la deuxième branche est connecté par sa source à la borne M et par son drain au drain d'un transistor MOS à canal P 44G dont la source est reliée à la ligne 21' d'alimentation de la tension de lecture Vr. Côté troisième branche, le transistor 43G est connecté à la ligne d'alimentation Vr par l'intermédiaire d'un transistor MOS à canal P 45G, la source du transistor 43G étant connectée à la masse.

La même structure est reproduite côté droit de la figure pour la connexion de la borne NQ. Le transistor 41D de la première branche est encore monté en diode. Le transistor 44 D de la deuxième branche a sa grille reliée à celle du transistor 44G sur lequel il est monté en miroir de courant, le transistor 44G étant monté en diode avec sa grille interconnectée à son drain. Côté troisième branche, le transistor 45D est monté en diode avec sa grille interconnectée à son drain et a sa grille reliée à la grille du transistor 45G de la branche de gauche.

La mesure différentielle s'effectue au moyen d'un amplificateur opérationnel 46 dont les entrées inverseuse et non inverseuse respectives sont connectées aux points 47 et 48 d'interconnexion des transistors 45G, 43G de la troisième branche gauche et 44D et 42D de la deuxième branche droite. En outre, une résistance de mesure R relie les bornes d'entrée de l'amplificateur 46. La sortie OUT de l'amplificateur 46 fournit l'état de la cellule lue.

Un avantage du mode de réalisation de la figure 6 est qu'il permet de s'affranchir des dissymétries éventuelles des constitutions des transistors MOS de sélection et, plus précisément, des dissymétries entre les capacités présentes dans le circuit. Il s'agit donc d'un amplificateur de mesure de résistance pure.

On notera que, comme pour l'alimentation de l'amplificateur 46 de la figure 6, seule la tension de lecture Vr alimente les miroirs de courant.

La figure 7 représente un autre exemple d'amplificateur de lecture différentielle applicable aux cellules de stockage de la figure 5. La lecture s'effectue ici en tension. L'amplificateur est constitué de deux transistors MOS (ici à canal N 51G et 51D) reliant respectivement les bornes Q et NQ à la masse M, l'un des transistors (par exemple 51G) étant monté en diode et les grilles des transistors 51G et 51D étant interconnectées. Il s'agit donc d'un miroir de courant équilibrant les tensions entre les bornes Q et NQ en lecture. Le miroir de courant amplifie le décalage, la branche de gauche fixant le courant pour l'autre branche. Par conséquent, si la résistance de la branche de gauche Q de la cellule sélectionnée est plus faible que la résistance de droite de cette cellule, un courant plus important circule dans cette branche de gauche. Comme le transistor miroir de l'autre branche appelle le même courant, le fait que sa résistance soit plus forte conduit à ce que le point A de lecture en tension chute à une tension basse (la masse aux résistances série des transistors à l'état passant près). Ce point A est relié à la grille d'un transistor MOS 52 de lecture, connecté en série avec une source de courant constant 53 entre la borne 21' d'application de la tension de lecture Vr et la masse M. Le point d'interconnexion entre le transistor 52 et la borne 53 traverse, le cas échéant, un inverseur 54 dont la borne de sortie fournit l'état de la cellule sélectionnée. Quand le point A est à un potentiel voisin de la masse, le transistor 52 est bloqué. Dans le cas inverse, ce transistor conduit. On obtient bien un basculement de la sortie OUT de l'amplificateur de lecture différentielle.

Selon une variante de réalisation, le point de lecture (grille du transistor 52) est relié à la ligne Q pourvu que ce soit alors le transistor 51D de la ligne qui soit monté en diode.

Comme pour le montage de la figure 6, lorsqu'on veut effectuer une stabilisation d'une des cellules mémoire, celle-ci est sélectionnée grâce à son signal WLi (figure 5) et on rend conducteur le transistor MNP1 ou MNP2 (signaux Pg1 et Pg2) de la branche dont on souhaite diminuer la valeur de la résistance de programmation en silicium polycristallin.

La figure 8 représente un autre mode de réalisation d'une cellule d'extraction selon l'invention. Cette cellule est basée sur l'utilisation d'un amplificateur ou comparateur avec hystérésis (communément appelée trigger de Schmitt) 61 constituant en même temps un élément de lecture différentielle.

Comme pour les autres modes de réalisation, la cellule comporte deux branches parallèles comprenant, chacune en série entre des bornes E et M d'application d'une tension d'alimentation, un élément résistif RP1, RP2 de différenciation et au moins un interrupteur constituant un transistor de confirmation MNP1, MNP2.

Dans l'exemple de la figure 8, chaque branche comporte également, pour sa lecture, un transistor MOS à canal P 62G, 62D reliant la borne E à une première borne de l'élément résistif RP1, RP2 respectivement et un transistor MOS à canal N 63G, 63D reliant respectivement l'autre borne de l'élément résistif RP1, RP2 à la masse M. Les grilles respectives des transistors 63G et 63D sont reliées au drain du transistor opposé, c'est-à-dire aux drains respectifs des transistors de programmation MNP1 et MNP2.

Les éléments résistifs RP1 et RP2 sont chacun constitués de deux résistances en série RP11, RP12 et RP21, RP22 dont les points milieux respectifs sont connectés aux entrées non inverseuses et inverseuses du trigger de Schmitt 61. Les sorties respectives du trigger de Schmitt sont connectées aux grilles des transistors 62G et 62D.

La borne E d'alimentation positive est connectée aux tensions Vp et Vr au moyen d'un circuit d'interrupteurs K. Ici, une variante du circuit d'interrupteurs a été illustrée sous la forme de deux interrupteurs K1 et K2 reliant respectivement les bornes 21' et 21" d'application des tensions Vr et Vp à la borne E. Bien entendu, les interrupteurs K1 et K2 ne sont pas fermés simultanément.

En lecture, dès que la cellule est alimentée sous la tension Vr, le trigger de Schmitt 61 rend passant les deux transistors 62G et 62D. Le montage à bascule du bas de la cellule (transistors 63G et 63D) détecte le déséquilibre entre les résistances RP1 et RP2. Le trigger 61 lit ce déséquilibre et bloque le transistor 62G ou 62D de la branche possédant la valeur de résistance RP1 ou RP2 la plus élevée.

Un avantage de la cellule mémoire de la figure 8 est qu'une fois la lecture effectuée, aucun courant ne circule dans la cellule.

Un autre avantage de la présence du trigger 61 est qu'il permet la détection d'un faible déséquilibre sans attendre que la bascule 63G, 63D ait bloqué complètement un des transistors 63G et 63D.

Dans l'exemple représenté, les sorties respectives directes Q et inverse NQ de la cellule sont constituées par les grilles des transistors 63D et 63G. En variante et comme cela est illustré en pointillés en figure 8, les grilles des transistors 62G et 62D (les sorties du trigger de Schmitt) peuvent également servir de sortie de la cellule.

Pour confirmer l'état initial (de fabrication) de la cellule, les signaux Pg1 et Pg2 sont confondus. On rend simultanément passants les transistors MNP1 et MNP2. La programmation ou stabilisation confirme alors l'état initial en diminuant la valeur de la résistance RP1 ou RP2 qui, à l'état issu de fabrication, présente déjà une valeur légèrement inférieure.

On notera que le mode de réalisation de la figure 8 est compatible avec l'utilisation d'une seule tension d'alimentation, celle-ci étant alors fixée au niveau de la tension de stabilisation ou programmation Vp. En effet, en lecture, dès que l'état est confirmé par le trigger de Schmitt, on ne risque pas de programmer les résistances dans la mesure où il n'y a plus de courant. On doit pour cela veiller à ce que le courant de lecture ne dure pas suffisamment longtemps pour entraîner une programmation. En d'autres termes, la durée d'application de la tension d'alimentation de la cellule doit être choisie suffisamment faible pour être compatible avec l'utilisation d'une seule tension d'alimentation.

Dans le cas où les deux tensions sont utilisées, le trigger de Schmitt 61 est alimenté sous la tension Vr.

La figure 9 illustre un exemple de réalisation du trigger de Schmitt 61 de la figure 8. Celui-ci comprend deux structures symétriques en parallèle entre une source de courant 64 alimentée par la tension Vp ou Vr (borne 21) et la masse M. Chaque structure comporte, entre la borne 65 de sortie de la source 64 et la masse, un transistor MOS à canal P 66D ou 66G dont les grilles respectives constituent les bornes inverseuse - et non-inverseuse + d'entrée, et dont les drains respectifs définissent les bornes de sortie reliées aux grilles des transistors 62G et 62D. Chacune des bornes 62G et 62D est reliée à la masse M par une association en série de deux transistors MOS à canal N 67G, 68G et 67D, 68D. Les transistors 67G et 67D sont montés en diodes, leurs grilles et drains respectifs étant interconnectés. Les grilles respectives des transistors 68G et 68D sont connectées aux drains des transistors 67D et 67G de la branche opposée. Un transistor MOS à canal N 69G ou 69D respectivement est monté en miroir de courant sur les transistors 67G et 67D. Ces transistors sont connectés entre les bornes 62D et 62G respectivement et, par l'intermédiaire de deux transistors MOS à canal N 70G et 70D, à la masse M pour garantir l'hystérésis pendant la lecture. Les grilles des transistors 70G et 70D reçoivent un signal CT de commande actif uniquement pendant la lecture et bloquant les transistors 70G et 70D afin d'éviter une consommation dans l'amplificateur après lecture.

Le fonctionnement d'un trigger de Schmitt 61 tel qu'illustré par la figure 9 est parfaitement connu. Dès qu'un déséquilibre apparaît entre le niveau de tension d'une des entrées - ou + (grille des transistors 66D et 66G), ce déséquilibre est verrouillé grâce à la structure en miroir de courant croisée de la partie basse du montage.

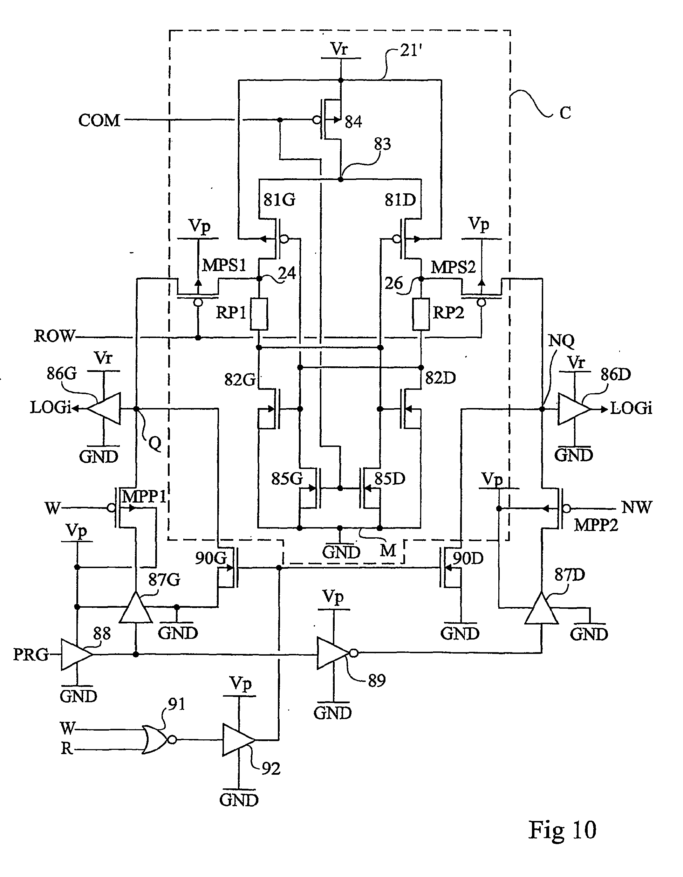

La figure 10 représente un troisième mode de réalisation d'une cellule selon la présente invention.

La cellule C proprement dite comprend deux branches parallèles constituées chacune d'un transistor MOS à canal P 81G, 81D, d'une résistance de programmation RP1, RP2, d'un transistor MOS à canal N 82G, 82D entre une borne 83 reliée à la tension d'alimentation de lecture Vr (borne 21') par l'intermédiaire d'un transistor MOS à canal P 84, et la masse M. Le transistor 84 est destiné à être commandé par un signal COM d'alimentation de la structure lors d'une lecture. Quand il est ouvert, aucune consommation n'est engendrée dans les branches parallèles décrites précédemment. Le signal COM est également envoyé aux grilles de deux transistors MOS à canal N 85G, 85D connectés entre les grilles respectives des transistors 81G et 81D et la masse. Les grilles des transistors 81G et 82G sont interconnectées au drain du transistor 82D tandis que les grilles des transistors 81D et 82D sont interconnectées au drain du transistor 82G, de façon à stabiliser l'état lu.

Les bornes 24, 26 des résistances RP1 et RP2 opposées aux transistors 82 sont respectivement reliées, par l'intermédiaire de transistors MOS à canal P de sélection MPS1 et MPS2, à des bornes Q et NQ de sortie de la cellule. De façon optionnelle, ces bornes Q et NQ sont reliées par l'intermédiaire d'amplificateurs suiveurs ou adaptateurs de niveau 86G et 86D générant des signaux logiques LOGi et NLOGi d'état de lignes de bit de la structure. Les transistors de sélection MPS1 et MPS2 sont commandés par un signal ROW de sélection de la cellule dans une colonne du type de celle représentée en figure 5. En se contentant d'une lecture de la cellule, la structure décrite précédemment permet bien d'obtenir, sur les bornes Q et NQ, l'état programmé de la cellule identifiée par la différence de valeur des résistances RP1 et RP2, même infime. Cette différence est amplifiée et l'état de la cellule est stabilisé grâce à sa structure croisée.

La stabilisation d'une cellule telle qu'illustrée par la figure 10 s'effectue grâce à deux transistors de stabilisation MPP1 et MPP2 (ici des transistors MOS à canal P) dont les drains respectifs sont connectés aux bornes Q et NQ (comme dans les figures précédentes) et dont les sources respectives sont destinées à recevoir la tension de stabilisation Vp. Les grilles des transistors MPP1 et MPP2 reçoivent les signaux Pg1 et Pg2. On notera toutefois que, s'agissant de transistors MOS à canal P, les états de ces signaux doivent être inversés par rapport aux structures précédemment décrites utilisant des transistors à canal N.

Avant sélection de la cellule, les transistors MPS1 et MPS2 sont tous deux bloqués par le signal ROW. La structure est donc isolée.

Une lecture commence par la mise à l'état haut du signal COM qui impose un niveau bas à l'ensemble des noeuds de la structure de la cellule. Lorsque le signal COM est remis à zéro, les grilles des transistors 81D et 85D sont chargées à travers la résistance RP1 tandis que les grilles des transistors 81G et 85G sont chargées à travers la résistance RP2, les capacités de grilles étant équivalentes par symétrie. En supposant que la résistance RP1 présente la valeur la plus faible, le drain du transistor 82G a un potentiel supérieur au drain du transistor 82D. Cette réaction s'amplifie pour donner un niveau haut sur la borne 24 et un niveau bas sur la borne 26. Cette opération est faite une seule fois tant que la tension d'alimentation Vr est maintenue.

Pour lire cette cellule, on la sélectionne par la mise à l'état haut du signal ROW. Les transistors MPS1 et MPS2 sont alors rendus passants, ce qui permet de transférer l'état des noeuds 24 et 26 sur les bornes Q et NQ, donc sur les lignes de bits Q et NQ générant les niveaux logique de sortie LOGi et NLOGi.

Pour stabiliser la cellule de la figure 10, on part d'un état où les transistors de sélection MPS1 et MPS2 sont bloqués. On commute le signal COM à l'état haut pour tirer les drains respectifs des transistors 82G et 82D à la masse. Comme le transistor 84 est bloqué, toute fuite de courant vers l'alimentation Vr est impossible.

On impose alors grâce à l'un des transistors MPP1 et MPP2, un niveau de tension suffisant (Vp) sur la borne Q ou NQ selon la résistance RP1 ou RP2 que l'on souhaite programmer par diminution irréversible de sa valeur. Puis, on provoque la fermeture des transistors MPS1 et MPS2 par la commutation du signal ROW. La tension de programmation est immédiatement transférée sur la résistance à programmer, alors que le noeud NQ ou Q opposé reste flottant.

Les tensions de programmation et de lecture peuvent être différentes comme cela sera exposé ci-après.

Dans le montage illustré en figure 10, les sources respectives des transistors MPP1 et MPP2 sont reliées en sortie d'éléments suiveurs 87G et 87D alimentés par la tension de programmation Vp. Les entrées respectives des éléments suiveurs 87G et 87D reçoivent la tension Vp au moyen d'un amplificateur suiveur 88 dont l'entrée reçoit un signal Prg binaire de déclenchement d'une programmation et dont la sortie est reliée directement en entrée de l'amplificateur 87G et, par l'intermédiaire d'un inverseur 89 alimenté par la tension Vp, en entrée de l'amplificateur 87D. Le rôle de l'inverseur 89 est de sélectionner celle des branches à soumettre à la tension Vp selon l'état du signal PRG. Dans ce cas, les transistors MPP1 et MPP2 peuvent être commandés par un même signal. En l'absence d'inverseur 89, on utilise des signaux Pg1 et Pg2 séparés.

Pour éviter une inversion accidentelle de l'état de la cellule quand les transistors de sélection sont fermés en raison de niveau de précharge sur des lignes non-contrôlées de la structure, on prévoit deux transistors, respectivement 90G et 90D (ici des transistors MOS à canal N), reliant les lignes respectivement Q et NQ à la masse. Ces transistors sont commandés simultanément par une combinaison de signaux W et R indicateurs respectivement par un état haut d'une phase d'écriture et d'une phase de lecture. Ces deux signaux sont combinés par une porte de type NON-OU Exclusif 91 dont la sortie traverse un amplificateur décaleur de niveau 92, alimenté par la tension Vp, avant d'attaquer les grilles des transistors 90G et 90D. Cette structure permet de tirer les noeuds Q et NQ à la masse avant chaque opération de lecture.

La génération des signaux de commande de la structure de la figure 10 est à la portée de l'homme du métier à partir des indications fonctionnelles données ci-dessus.

Bien entendu, la présente invention est susceptible de diverses variantes et modifications qui apparaîtront à l'homme de l'art. En particulier, les dimensionnements des résistances en silicium polycristallin en vue d'obtenir une valeur nominale dépendent de l'application et sont à la portée de l'homme du métier à partir des indications fonctionnelles données ci-dessus. De plus, les valeurs des contraintes en tension ou en courant pour la mise en oeuvre de l'invention sont à la portée de l'homme du métier à partir des indications fonctionnelles données ci-dessus. En outre, bien que l'invention ait été décrite en relation avec des transistors MOS à canal N, sa structure se transpose aisément à des transistors MOS à canal P, les résistances des cellules étant alors connectées au potentiel le plus bas (négatif) d'alimentation. Enfin, on notera que l'invention est aisément transposable d'une technologie à une autre.

**Revendications**

1. Cellule intégrée (1) comprenant deux resistances passives (Rd, Rg; Rp1, Rp2), pour extraction d'une valeur binaire basée sur une différence de valeurs entre ces deux résistances passives (Rd, Rg ; Rp1, Rp2), la cellule étant telle que lesdites résistances sont dimensionnées pour avoir des valeurs nominales identiques, et la cellule comportant :

   des moyens de lecture binaire du signe de la différence de valeurs entre lesdites résistances ; et

   **caracterisée en ce que** la cellule comporte :

   des moyens de diminution irréversible de la valeur de uniquement celle desdites résistances qui, lors d'une première lecture, a indiqué une résistance de valeur moindre, pour rendre invariable ledit signe de différence de valeurs.

2. Cellule mémoire selon la revendication 1 **caractérisée en ce que** ladite modification de valeur consiste à diminuer, de façon irréversible et stable dans la plage de courants de fonctionnement en lecture de la cellule, la valeur d'une desdites résistances (Rd, Rg ; Rp1, Rp2).

3. Cellule selon l'une quelconque des revendications 1 à 2, **caractérisée en ce que** les résistances (Rd, Rg ; Rp1, Rp2) sont en silicium polycristallin.

4. Cellule selon les revendications 2 et 3, **caractérisée en ce que** ladite diminution de valeur est provoquée en imposant temporairement, dans la résistance correspondante (Rd, Rg), la circulation d'un courant qui soit supérieur au courant pour lequel la valeur de cette résistance est maximum.

5. Cellule (1) selon l'une quelconque des revendications 1 à 4, **caractérisée en ce qu'**elle est appliquée à l'extraction d'une valeur binaire à partir d'une propagation d'un front d'un signal de déclenchement dans deux chemins électriques, et **en ce qu'**elle comporte, entre deux bornes (2, 3) d'application d'une tension, deux branches parallèles comprenant chacune, en série :

   une desdites résistances (Rd, Rg) de différenciation des chemins électriques ;
   un transistor de lecture (MN1d, MN1g), le point milieu entre la résistance et le transistor de lecture de chaque branche définissant une borne de sortie (Q, NQ) de la cellule, et la grille du transistor de lecture de chaque branche étant reliée à la borne de sortie de l'autre branche ; et
   un transistor de sélection (MN2d, MN2g) .

6. Cellule selon la revendication 5, **caractérisée en ce que** chaque branche comporte en outre un transistor de stabilisation (MN3d, MN3g) reliant sa borne de sortie (Q, NQ) à ladite borne (3) d'application de tension opposée à celle à laquelle est connectée la résistance (Rd, Rg) de la branche concernée.

7. Cellule selon la revendication 6 dans son rattachement à la revendication 2, **caractérisée en ce que** les transistors de stabilisation (MN3d, MN3g) servent à provoquer ladite diminution de la valeur d'une des résistances (Rd, Rg).

8. Cellule selon l'une quelconque des revendications 5 à 7, **caractérisée en ce que** ladite tension est choisie entre une tension relativement faible de lecture (Vr) et une tension relativement élevée de stabilisation (Vp) de l'état initial de la cellule.

9. Cellule selon l'une quelconque des revendications 1 à 4, **caractérisée en ce qu'**elle comporte :

   deux branches parallèles comprenant chacune une desdites résistances (RP1, RP2) connectée entre une première borne (E) d'alimentation et une borne de lecture différentielle (4, 6) de l'état de la cellule ; et
   au moins un interrupteur de programmation (MNP1, MNP2 ; MPP1, MPP2) reliant une desdites bornes de lecture à une deuxième borne (M) d'application de la tension d'alimentation.

10. Cellule mémoire selon la revendication 9, **caractérisé en ce que** chaque branche comporte un interrupteur de programmation (MNP1, MNP2 ; MPP1, MPP2).

11. Cellule mémoire selon la revendication 9 ou 10, **caractérisée en ce qu'**une des bornes d'alimentation (E, M) est reliée, par l'intermédiaire d'un sélecteur (K), à au moins deux tensions d'alimentation parmi lesquelles une tension d'alimentation de fonctionnement en lecture (Vr) relativement faible et une tension d'alimentation de stabilisation (Vp) relativement élevée.

**12.** Cellule mémoire selon l'une quelconque des revendications 9 à 11, **caractérisée en ce qu'**au moins un transistor de sélection (MNS1, MNS2 ; MPP1, MPP2) est associé en série avec chaque dite résistance entre ladite première borne d'alimentation (E) et ladite borne de lecture (4, 6) correspondante.

**13.** Cellule mémoire selon l'une quelconque des revendications 9 à 12, **caractérisée en ce que** chaque dite résistance est connectée à la deuxième borne d'alimentation (M) par un interrupteur de verrouillage (63G, 63D ; 85G, 85D) dont la borne de commande est reliée à la résistance de l'autre branche.

**14.** Cellule mémoire selon l'une quelconque des revendications 9 à 13, **caractérisée en ce qu'**elle comporte un amplificateur différentiel (61, 5) de lecture de l'état de la cellule.

**15.** Cellule mémoire selon l'une quelconque des revendications 9 à 14 **caractérisée en ce que** chaque branche comporte, de part et d'autre de sa résistance (Rp1, Rp2), respectivement un transistor à canal N (82G, 82D) et un transistor à canal P (81G, 81D), dont les grilles sont connectées ensemble à une borne de la résistance de l'autre branche.

**16.** Procédé de programmation d'une cellule mémoire selon l'une quelconque des revendications 1 à 15, **caractérisé en ce qu'**il consiste, pour rendre irréversible le signe de la différence entre les deux résistances, à imposer temporairement, dans l'une des résistances, la circulation d'un courant de stabilisation supérieur à un courant pour lequel la valeur de la résistance de la branche concernée présente un maximum.

**17.** Procédé selon la revendication 16, **caractérisé en ce qu'**il comprend les étapes suivantes :

augmenter pas à pas le courant dans la résistance sélectionnée ; et
mesurer, après chaque application d'un courant supérieur, la valeur de cette résistance dans son environnement fonctionnel de lecture.

**18.** Procédé selon la revendication 16 ou 17, **caractérisé en ce qu'**il consiste à utiliser une table prédéterminée de correspondance entre le courant de stabilisation et la résistance finale souhaitée pour appliquer, à la résistance de programmation sélectionnée, le courant de programmation adapté.

**19.** Procédé de commande en stabilisation de la valeur d'une cellule (1) selon l'une quelconque des revendications 5 à 15, **caractérisé en ce qu'**il comprend les étapes suivantes :

provoquer une lecture d'un état initial de la cellule ; et
soumettre temporairement, celle des résistances qui est associée à la branche fournissant un état haut en sortie, à un courant de contrainte supérieur à un courant (Im) pour lequel la valeur de la résistance présente un maximum.

**20.** Procédé selon la revendication 19, **caractérisé en ce que** le courant de contrainte est choisi dans une table prédéterminée de correspondance entre le courant de contrainte et la résistance finale souhaitée.

**21.** Circuit de stockage et d'extraction d'un code binaire sur n bits dans une puce de circuit intégré comportant :

n cellules (1) conformes à l'une quelconque des revendications 1 à 15; et
une unité centrale (4) de commande.

**22.** Circuit selon la revendication 21, **caractérisé en ce que** les n bits contenus dans les cellules (1) sont extraits en parallèle.

**23.** Circuit d'identification d'une puce de circuit intégré, **caractérisé en ce qu'**il comporte un circuit conforme à la revendication 21 ou 22.

**Claims**

**1.** An integrated cell (1) comprising two passive resistors (Rd, Rg; Rp1, Rp2) for extracting a binary value based on a difference between the values of the two passive resistors (Rd, Rg; Rp1, Rp2), the cell being such that said resistors are sized to have identical nominal values, the cell comprising:

means for a binary reading of the sign of the difference between said resistors; and

**characterized in that** the cell comprises means for irreversibly reducing only the one of said resistors, that, upon a first reading has indicated a lower resistance, to make said difference sign invariable.

**2.** The cell of claim 1, wherein said value modification consists of decreasing, in an irreversible and stable manner, within the read operating current range of the cell, the value of one of said resistors (Rd, Rg; Rp1, Rp2).

**3.** The cell of claim 1 or 2, wherein the resistors (Rd, Rg; Rp1, Rp2) are made of polysilicon.

**4.** The cell of claims 2 and 3, wherein the value decrease is caused by temporarily imposing, in the corresponding resistor (Rd, Rg), a current which is greater than the current for which the value of the resistor is maximum.

**5.** The cell (1) of any of claims 1 to 4, applied to the extraction of a binary value based on a propagation of an edge of a triggering signal in two electric paths, comprising, between two voltage supply terminals (2, 3), two parallel branches each comprising, in series:

one of said resistors (Rd, Rg) for differentiating the electric paths;
a read transistor (MN1d, MN1g), the junction point of the resistor and the read transistor of each branch defining an output terminal (Q, NQ) of the cell, and the gate of the read transistor of each branch being connected to the output terminal of the other branch; and
a selection transistor (MN2d, MN2g).

**6.** The cell of claim 5, wherein each branch further comprises a stabilization transistor (MN3d, MN3g) connecting its output terminal (Q, NQ) to said terminal (3) of application of a voltage opposite to that to which the resistor (Rd, Rg) of the involved branch is connected.

**7.** The cell of claims 2 and 6, wherein the stabilization transistors (MN3d, MN3g) are used to cause said decrease in the value of one of the resistors (Rd, Rg).

**8.** The cell of any of claims 5 to 7, wherein said voltage is chosen from a relatively low read voltage (Vr) and a relatively high voltage of stabilization (Vp) of the initial cell state.

**9.** The cell of any of claims 1 to 4, comprising:

two parallel branches each comprising one of said resistors (RP1, RP2) connected between a first supply terminal (E) and a terminal (4, 6) for differentially reading the cell state; and
at least one programming switch (MNP1, MNP2; MPP1, MPP2) connecting one of said read terminals to a second terminal (M) of application of the supply voltage.

**10.** The memory cell of claim 9, wherein each branch comprises a programming switch (MNP1, MNP2; MPP1, MPP2).

**11.** The memory cell of claim 9 or 10, wherein one of the supply terminals (E, M) is connected, via a selector (K), to at least two supply voltages, among which a relatively low read operation supply voltage (Vr) and a relatively high stabilization supply voltage (Vp).

**12.** The memory cell of any of claims 9 to 11, wherein at least one selection transistor (MNS1, MNS2; MPP1, MPP2) is associated in series with each said resistor between the first supply terminal (E) and said corresponding read terminal (4, 6).

**13.** The memory cell of any of claims 9 to 12, wherein each said resistor is connected to the second supply terminal (M) by a latch (63G, 63D; 85G, 85D) having its control terminal connected to the resistor of the other branch.

**14.** The memory cell of any of claims 9 to 13, comprising a differential amplifier (61, 5) for reading the cell state.

**15.** The memory cell of any of claims 9 to 14, wherein each branch comprises, on either side of its resistor (Rp1, Rp2), respectively an N-channel transistor (82G, 82D) and a P-channel transistor (81G, 81D), the gates of which are connected together to a terminal of the resistor of the other branch.

**16.** A method for programming the memory cell of any of claims 1 to 15, consisting, to make irreversible the sign of the difference between the two resistances, of temporarily imposing, in one of the resistors, a stabilization current greater than a current for which the value of the resistor of the involved branch exhibits a maximum.

**17.** The method of claim 16, comprising the steps of:

increasing step-by-step the current in the selected resistor; and
measuring, after each application of a higher current, the value of this resistor in its functional read environment.

**18.** The method of claim 16 or 17, consisting of using a predetermined table of correspondence between the stabilization current and the desired final resistance to apply, to the selected programming resistor, the adapted programming current.

**19.** A method for controlling the stabilization of the value of a cell (1) according to any of claims 5 to 15, comprising the steps of:

causing the reading of an initial state of the cell; and
temporarily submitting that of the resistors which is associated with the branch providing a high output state, to a constraint current greater than a current (Im) for which the value of the resistance exhibits a maximum.

20. The method of claim 19, wherein the constraint current is selected from a predetermined table of correspondence between the constraint current and the desired final resistance.

21. A circuit for storing and extracting a binary code over n bits in and from an integrated circuit chip, comprising:

    n cells (1) according to any of claims 1 to 15, and a central control unit (4).

22. The circuit of claim 21, wherein the n bits contained in the cells (1) are extracted in parallel.

23. A circuit for identifying an integrated circuit chip, comprising the circuit of claim 21 or 22.


**Patentansprüche**

1. Eine integrierte Zelle (1), die zwei passive Widerstände (Rd, Rg; Rp1, Rp2), zum Extrahieren eines binären Wertes basierend auf einer Differenz zwischen den Werten von den zwei passiven Widerständen (Rd, Rg; Rp1, Rp2) aufweist, wobei die Zelle derart ist, dass die Widerstände Größen besitzen um identische nominelle Werte zu besitzen, wobei die Zelle Folgendes aufweist:

    Mittel für ein binäres Auslesen bzw. Lesen des Vorzeichens der Differenz zwischen den Widerständen; und

    **dadurch gekennzeichnet, dass** die Zelle Mittel aufweist zum irreversiblen Reduzieren von nur einem der Widerstände, so dass, nachdem ein erstes Lesen einen niedrigeren Widerstand angezeigt hat, das Differenzvorzeichen invariabel gemacht wird.

2. Zelle nach Anspruch 1, wobei die Wertmodifikation aus einem Verringern des Wertes von einem der Widerstände (Rd, Rg; Rp1, Rp2) besteht und zwar auf eine irreversible und stabile Art und Weise innerhalb des Lesebetriebstrombereichs der Zelle.

3. Zelle nach Anspruch 1 oder 2, wobei die Widerstände (Rd, Rg; Rp1, Rp2) aus Polysilizium hergestellt sind.

4. Zelle nach den Ansprüchen 2 und 3, wobei die Werteverringerung verursacht wird durch temporäres Aufprägen in dem entsprechenden Widerstand (Rd, Rg), eines Stroms der größer ist als der Strom für den der Wert des Widerstands maximal ist.

5. Zelle (1) nach irgendeinem der Ansprüche 1 bis 4, angelegt auf die Extrahierung eines binären Wertes basierend auf einer Ausbreitung einer Kante bzw. Flanke eines Trigger- bzw. Auslösesignals in zwei elektrischen Pfaden, die zwischen zwei Spannungsversorgungsanschlüssen (2, 3), zwei parallele Zweige aufweist, die jeweils in Reihe Folgendes aufweisen:

    einen der Widerstände (Rd, Rg) zum Differenzieren der elektrischen Pfade;
    einen Lesetransistor (MN1d, MN1g), wobei der Kreuzungspunkt des Widerstands und des Lesetransistors von jedem Zweig einen Ausgangsanschluss (Q, NQ) der Zelle definieren und das Gatter des Lesetransistors von jedem Zweig mit dem Ausgangsanschluss des anderen Zweigs verbunden ist; und
    einen Selektionstransistor (MN2d, MN2g).

6. Zelle nach Anspruch 5, wobei jeder Zweig ferner einen Stabilisierungstransistor (MN3d, MN3g) aufweist, der seinen Ausgangsanschluss (Q, NQ) mit dem Anschluss (3) der Anwendung einer Spannung entgegensetzt zu jener mit der der Widerstand (Rd, Rg) des involvierten Zweigs verbunden ist.

7. Zelle nach den Ansprüchen 2 und 6, wobei die Stabilisierungstransistoren (MN3d, MN3g) genutzt werden zum Verursachen der Abnahme des Wertes von einem der Widerstände (Rd, Rg).

8. Zelle nach irgendeinem der Ansprüche 5 bis 7, wobei die Spannung aus einer relativ niedrigen Lesespannung (Vr) und einer relativ hohen Stabilisierungsspannung (Vp) des initialen Zellenzustands gewählt wird.

9. Zelle nach irgendeinem der Ansprüche 1 bis 4, die Folgendes aufweist:

    zwei parallele Zweige die jeweils einen der Transistoren (RP1, RP2) aufweisen, die zwischen einem ersten Versorgungsanschluss (E) und einem Anschluss (4, 6) zum differentiellen Lesen des Zellenzustands verbunden sind; und
    wenigstens einem Programmierungsschalter (MNP1, MNP2; MPP1, MPP2), der an einen der Leseanschlüsse mit einem zweiten Anschluss (M) zum Anlegen der Vorsorgungsspannung verbindet.

10. Speicherzelle nach Anspruch 9, wobei jeder Zweig einen Programmierungsschalter (MNP1, MNP2; MPP1, MPP2) aufweist.

**11.** Speicherzelle nach Anspruch 9 oder 10, wobei einer der Versorgungsanschlüsse (E, M) verbunden ist, über einen Selektor (K), mit wenigstens zwei Versorgungsspannungen, unter denen eine relativ niedrige Lesebetriebsversorgungsspannung (Vr) und eine relativ hohe Stabilisierungsversorgungsspannung (Vp) ist.

**12.** Speicherzelle nach irgendeinem der Ansprüche 9 bis 11, wobei wenigstens ein Selektionstransistor (MNS1, MNS2; MPP1, MPP2) seriell bzw. in Reihe assoziiert ist mit jedem Widerstand zwischen dem ersten Versorgungsanschluss (E) und dem korrespondierenden Leseanschluss (4, 6).

**13.** Speicherzelle nach irgendeinem der Ansprüche 9 bis 12, wobei jeder Transistor mit dem zweiten Versorgungsanschluss (M) über einen Riegel bzw. Latch (63G, 63D; 85G, 85D) verbunden ist, wobei das Latch seinen Steueranschluss mit dem Widerstand des anderen Zweigs verbunden hat.

**14.** Speicherzelle nach irgendeinem der Ansprüche 9 bis 13, die einen differentiellen Verstärker (61, 5) zum Lesen des Zellenzustands aufweist.

**15.** Speicherzelle nach irgendeinem der Ansprüche 9 bis 14, wobei jeder Zweig Folgendes aufweist: auf jeder Seite von seinem Widerstand (Rp1, Rp2) entsprechend einen N-Kanal-Transistor (82G, 82D) und einen P-Kanal-Transistor (81G, 81D) wobei deren Gatter miteinander mit einem Anschluss des Widerstands des anderen Zweigs verbunden sind.

**16.** Ein Verfahren zum Programmieren der Speicherzelle nach irgendeinem der Ansprüche 1 bis 15, das daraus besteht um das Vorzeichen der Differenz zwischen den zwei Widerständen irreversibel zu machen, in einem der Widerstände temporär einen Stabilisierungsstrom aufzuerlegen, der größer ist als ein Strom für den Wert des Widerstands des involvierten Zweigs ein Maximum zeigt.

**17.** Verfahren nach Anspruch 16, das die folgenden Schritte aufweist:

Erhöhen des Stroms schrittweise in dem ausgewählten Widerstand; und
Messen des Werts dieses Widerstands in seiner funktionalen Leseumgebung nach jeder Anwendung eines höheren Stroms.

**18.** Verfahren nach Anspruch 16 oder 17, das besteht aus dem Nutzen einer vorher bestimmten Korrespondenztabelle zwischen dem Stabilisierungsstrom und dem gewünschten finalen Widerstand zum Anlegen des adaptierten Programmierstroms an den ausgewählten zu programmierenden Widerstand.

**19.** Ein Verfahren zum Steuern der Stabilisierung des Werts einer Zelle 1, gemäß irgendeinem der Ansprüche 5 bis 15, wobei das Verfahren die Folgenden Schritte aufweist:

Bewirken des Lesens eines Initialzustands der Zelle; und
temporäres Unterwerfen jenes der Widerstände, der mit dem Zweig der einen hohen Ausgabezustand vorsieht assoziiert ist, mit einem eingeprägten Strom der größer als ein Strom (Im) ist für den der Wert des Widerstands ein Maximum zeigt.

**20.** Verfahren nach Anspruch 19, wobei der eingeprägte Strom von einer vorherbestimmten Korrespondenztabelle zwischen dem eingeprägten Strom und dem gewünschten finalen Widerstand ausgewählt wird.

**21.** Eine Schaltung zum Speichern und Extrahieren eines binären Codes über n Bits in und von einem integrierten Schaltungs-Chip und zwar Folgendes aufweisend:

n Zellen (1) gemäß irgendeinem der Ansprüche 1 bis 15, und
eine zentrale Steuereinheit (4).

**22.** Schaltung nach Anspruch 21, wobei die n Bits die in den Zellen (1) enthalten sind, parallel extrahiert werden.

**23.** Eine Schaltung zum Identifizieren eines integrierten Schaltungs-Chips, die die integrierte Schaltung nach Anspruch 21 oder 22 aufweist.

Fig 1

Fig 4

Fig 2

Fig 3

Fig 5

Fig 6

Fig 8

E
21
64
65
61

+ 66G          66D  −

62G ◄          ► 62D

CT

67G    69G    69D    67D

68G    70G    70D    68D

GND        M

**Fig 9**

Q          NQ

Vr  21'
53

54

OUT ◄          A

52

GND

51G    51D

GND    M

Pg1  MNP1        MNP2  Pg2

GND        M

**Fig 7**

Fig 10

**EP 1 483 763 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2823340
- FR 2823341
- EP 0863546 A
- EP 0511560 A